# EUROPEAN PATENT SPECIFICATION

(11) **EP 4 242 648 B1**
(45) Date of publication and mention of the grant of the patent: **19.11.2025**
(21) Application number: 23460007.0
(22) Date of filing: 01.03.2023
(51) Int. Cl.: G01N 27/30, G01N 27/327

(54) **COMPOSITE ELECTRODES FOR ELECTROCHEMICAL MEASUREMENTS**
VERBUNDELEKTRODEN FÜR ELEKTROCHEMISCHE MESSUNGEN
ÉLECTRODES COMPOSITES POUR MESURES ÉLECTROCHIMIQUES

(30) Priority: 08.03.2022 PL 44057722
(43) Date of publication of application: 13.09.2023
(73) Proprietor: Politechnika Gdanska, 80-233 Gdansk (PL)
(72) Inventor: Bogdanowicz, Robert, 80-287 Gdansk (PL); Ficek, Mateusz, 76-200 Slupsk (PL); Rycewicz, Michal, 80-119 Gdansk (PL); Majchrowicz, Daria, 80-461 Gdansk (PL); Dettlaff, Anna, 80-176 Gdansk (PL); Kowalski, Marcin, 86-300 Grudziac (PL); Brodowski, Mateusz, 83-120 Subkowy (PL)
(74) Representative: Pawlowska-Bajerska, Justyna

(56) References cited:
- CN-A- 111 058 011
- CARDOSO RAFAEL M ET AL: "3D-printed flexible device combining sampling and detection of explosives", SENSORS AND ACTUATORS B: CHEMICAL, vol. 292, 26 April 2019 (2019-04-26), pages 308 - 313, XP085683863, ISSN: 0925-4005, DOI: 10.1016/J.SNB.2019.04.126
- ZHAO Y Q ET AL: "Nanodiamond/poly (lactic acid) nanocomposites: Effect of nanodiamond on structure and properties of poly (lactic acid)", COMPOSITES PART B, ELSEVIER, AMSTERDAM, NL, vol. 41, no. 8, 17 September 2010 (2010-09-17), pages 646 - 653, XP027486328, ISSN: 1359-8368, [retrieved on 20101109], DOI: 10.1016/J.COMPOSITESB.2010.09.003
- DETTLAFF ANNA ET AL: "Conductive printable electrodes tuned by boron-doped nanodiamond foil additives for nitroexplosive detection", MICROCHIMICA ACTA, SPRINGER VIENNA, VIENNA, vol. 189, no. 8, 5 July 2022 (2022-07-05), XP037885419, ISSN: 0026-3672, [retrieved on 20220705], DOI: 10.1007/S00604-022-05371-W

## Description

The invention refers to an electrode for biochemical measurements and method of manufacturing - producing such electrode. The invention - the electrode can be applied for operation in electrochemical sensors and biochemical sensors for, e.g. pH, ions, bacteria, viruses, or protein markers.

An invention is known from patent application ref. WO 2020233160 A1 which describes flexible, translucent electrodes, and specifically, the method of producing a flexible, translucent electrode by additive manufacturing, i.e. 3D printing, from a metal mesh, and the applications of such electrode.

A graphite-polymer composite electrode is known from the description of patent ref. KR 101730396 B1 for application in various electrochemical techniques, such as cyclic voltage amperometry of various redox pairs, amperometric detection of hydrogen peroxide, voltage amperometry of lead (II) ion stripping, electrodeposition of zinc, and electropolymerisation of aniline in an aqueous medium. A conductive PLA (polylactic acid) fibre is known from the description of patent ref. CN 102943315 B and the method of producing such fibre. A conductive fibre like this can be treated as an electrode material, an antistatic material, a low-temperature heating material, an electromagnetic shielding material, a heat-sensitive material, a gas-sensitive material, etc.

One of the most popular 3D printing techniques is FDM (Fused Deposition Modelling). 3D printing with carbon-based conductive fibres has been adopted by analytical chemistry and electrochemistry. This is discussed in publications, like A. Ambrosini et al. "3D-printing technologies for electrochemical applications", Chem. Soc. Rev. 45, 2740-2755 (2016), or G.N. Meloni, "3D Printed and Microcontrolled: The One Hundred Dollars Scanning Electrochemical Microscope", Anal. Chem. 89, 8643-8649 (2017). Specifically, as the input material for electrodes applied in electrochemical sensors or biosensors, commercially available carbon black/PLA has been applied, as discussed in V. Katseli et al., "Single-step fabrication of an integrated 3D-printed device for electrochemical sensing applications", Electrochem. Commun. 103, 100-103 (2019). R.M. Cardoso et al., "3D-printed flexible device combining sampling and detection of explosives", Sensors Actuators, B Chem. 292, 308-313 (2019), describes graphene/PLA as an input material for electrodes.

An inconvenience, the drawbacks of the know solutions is instability over time and biofouling in biological media.

Diamonds have always spurred interest in humans due to their unique properties. They exhibit extremely high hardness (ca. 10,000 Vickers), chemical stability, biocompatibility, and transparency in a wide spectrum of optical radiation, from ultraviolet to far infrared. Due to their biocompatibility, chemical resistance, and very good mechanical performance, there is great potential in applications of diamond structures.

The properties of diamonds can also be customised by modifying the parameters of deposition, such as the temperature, duration, operating gas mixture composition, and substrate. The set of such unique properties has resulted in many applications of diamonds in many different fields of science, biomedicine, and technology, as discussed in Rifai, A. et al. "Polycrystalline Diamond Coating of Additively Manufactured Titanium for Biomedical Applications". ACS Appl. Mater. Interfaces 10, 8474-8484 (2018).

A method of producing diamond foils is known from the description of patent application ref. PL 425610 A. Thin diamond foils, also known as nanodiamond foils (NDF) are produced by microwave plasma-assisted chemical vapour deposition (MW PA CVD).

An inconvenience - the drawbacks of the known solutions is poor electrical conductivity and low mechanical stability.

Yong-Qing Zhao et al., "Nanodiamond/poly (lactic acid) nanocomposites: Effect of nanodiamond on structure and properties of poly (lactic acid)", Composites Part B: Engineering, 41, 8. 646-653(2010), describe the use of nanodiamond powders with PLA for potential biological applications prepared using methods of compound melting; however, the feasibility of their application in electrodes was not disclosed.

It has been indicated so far that several research groups are working with diamond foils and powders, focusing first on the process of material deposition, characterisation of the structures, and methods of transferring the resulting material to the target substrates. This is discussed in Lodes, M. A., Kachold, F. S. & Rosiwal, S. M., "Mechanical properties of micro- and nanocrystalline diamond foils", Philosophical Transactions of the Royal Society A: Mathematical, Physical and Engineering Sciences 373, 20140136 (2015), as well as Engenhorst, M. et al., "Thermoelectric transport properties of boron-doped nanocrystalline diamond foils", Carbon 81, 650-662 (2015). Bogdanowicz, R. et al., "Growth and Isolation of Large Area Boron-Doped Nanocrystalline Diamond Sheets: A Route toward Diamond-on-Graphene Heterojunction", Advanced Functional Materials 29, 1805242 (2019), present a process of foil deposition on a large surface area, characterised the properties of the foil, and demonstrated its potential applications. An effective method was also discussed for the production of thin, large-area diamond foils, disclosing interesting properties of electronic transfer, complete with efficient tunnelling in a diamond-on-graphene bonding configuration.

Seshan, V. et al., "Pick-up and drop transfer of diamond nanosheets", Nanotechnology 26, 125706 (2015), present a process of manufacturing and development of a transfer technique of the produced diamond foils using a viscoelastic stamp. The diamond foil sheets were then used for the production of mechanical resonators.

An application of electrodes made of a lot of materials with a wide potential window is known. An application is known in which boron-doped diamond layers and boron-doped carbon nanowalls are used as electrodes operating for the detection of paracetamol by cyclic voltage amperometry, as discussed in P. Niedzialkowski et al., "Comparison of the paracetamol electrochemical determination using boron-doped diamond electrode and boron-doped carbon nanowalls," Biosensors and Bioelectronics 126, 308-314 (2019). K. Siuzdak et al. demonstrated the production of boron-doped carbon nanowalls which featured unusual electrochemical properties. These authors discussed it in "Boron-Enhanced Growth of Micron-Scale Carbon-Based Nanowalls: A Route toward High Rates of Electrochemical Biosensing", ACS Applied Materials & Interfaces 9(15), 12982-12992 (2015).

Anyway, the big challenge and inconvenience of known solutions of silicon, niobium, or molybdenum electrodes is the necessity of applying high temperatures and expensive, rigid deposition substrates.

The goal of this invention was to provide such an electrode and its obtaining method that the invention that will have the following advantages over the state of the art: high electrical conductivity, mechanical stability, low cost and weight, enhanced flexibility, and feasibility of applying substrates sensitive to high temperature.

This invention refers to an electrode intended for application in electrochemical measurements of e.g. pH, ions, bacteria, viruses, or protein markers, and comprising an electrode made of two layers, with one layer made of conductive polylactic acid (PLA) fibre or conductive polylactic acid (PLA) fibre doped with graphene (graphen/PLA), being a graphene-polymer layer, in which the weight ratio of graphene to PLA was 0.5% to 20% of graphene by weight and 99.5% to 80% of PLA by weight in the same layer of the electrode. The PLA layer or the PLA/graphene layer is coated from the inner side, i.e. the bottom side, with nanodiamond foil (NDF) or a layer of nanodiamond powder (NDP), forming the inner or bottom layer of the electrode. The inner layer is 0.1 to 5 mm thick and coated from its bottom side with an outer layer of nanodiamond foil (NDF) or a layer of nanodiamond powder (NDP), and this layer is 50 nm to 1500 nm thick.
It is significant than from the outside, the electrode substrate, meaning the bottom side on the bottom layer of the electrode, an outer layer is formed being a nanodiamond foil (NDF) or a layer of nanodiamond powder (NDP), with NDP or NDF preferably doped with boron or nitrogen, and either of NDP or NDF produced with a known method of microwave plasma-assisted chemical vapour deposition (MW PA CVD). The electrode is thus formed by two parts (layers), being a uniform graphene/PLA composite or a layer of PLA, with the bottom side designated W1 in the figure, and this composite or layer, respectively, has another layer on its top, which means the electrode is coated from the bottom with an outer layer of NDF or NDP, designated W2 in the figure.
It is significant that the outer layer is up to 0.1% by weight of the entire electrode, it is formed on the electrode's substrate, which is a 3D-printed layer, on the graphene-polymer PLA electrode, at 150-300°C, where this temperature range applies both to the PLA 3D print or PLA/graphene 3D print and the deposition on the outer layer on the electrode. The base of the electrode, meaning its bottom side or the inner layer, is made by 3D printing. The outer layer is mechanically bonded to the inner layer, using mechanical deposition. The top layer made of nanodiamond foil (NDF) or nanodiamond powder (NDP) is a protective coating against aggressive chemical reagents and forms an electrochemical part of the electrode. The inner layer is formed of graphene/PLA and its thickness ranges from 0.1 mm to 5 mm. The outer layer is formed of nanodiamond foil (NDF) or nanodiamond powder (NDP) and is 50 nm to 1500 nm thick. The outer layer of NDF or NDP is the top side of the electrode, whereas if NDF is used for the outer layer, the growth surface on a tantalum substrate is oriented upward or downward, which affects other properties of the same layer, and the rough substrate of the layer is on the growth side of the tantalum substrate. This arrangement affects the method of producing an electrode by deposition of the outer layer on the produced inner layer of PLA./graphene. Preferably, the outer layer is an NDF layer with an inner layer of PLA/graphene.
PLA/graphen is named as PLA/graphen what means the same - a graphene-polymer layer.

Method of producing an electrode of conductive polylactic acid (PLA) fibre or conductive graphene-doped polylactic acid (PLA) fibre as an inner layer, comprising the step of production of a matrix which is 3D-printed by fused deposition melting (FDM) using a known method and by bonding with an outer layer, wherein the inner layer being the matrix is produced at a build surface temperature of 50-80°C, an extruder temperature of 210-230°C, a single layer thickness of 0.16-0.32 nm and with the filament flow rate through the extruder at 1.5-2 mm³/s. It is significant that according to the invention, the outer layer is a nanodiamond foil (NDF) or nanodiamond powder (NDP), preferably doped with boron or nitrogen, produced with the known method of microwave plasma-assisted chemical vapour deposition (MW PA CVD) in four subsequent steps, where the first step is nucleation on a substrate, preferably pre-polished and made of tantalum or molybdenum or niobium, followed by nucleation and a step of growth, and finally, with removal of superfluous suspension and drying. The nanodiamond foil (NDF) or nanodiamond powder (NDP) produced like so, being the outer layer in a quantity of up to 0.1% by weight of the entire electrode, is deposited directly on a 3D-printed matrix, where the matrix temperature required for the foil transfer is 150-300°C.

Preferably, the share of graphene in the inner layer of the electrode made of conductive polylactic acid (PLA) fibre doped with graphene is up to 5% by weight.

Preferably, the outer layer of nanodiamond foil (NDF) or nanodiamond powder (NDP) is deposited by mechanical means on top of the heated matrix, preferably using tweezers or a spatula.

Preferably, a matrix is printed on the outer layer made of nanodiamond foil (NDF) or nanodiamond powder, where the matrix is of conductive polylactic acid (PLA) fibre or graphene-doped conductive polylactic acid (PLA) fibre, followed by peeling off the nanodiamond foil (NDF) or nanodiamond powder with the outer layer already bonded to it.

The nanodiamond foils or nanodiamond powders applied in an electrode to serve as an outer layer which covers the inner layer made of graphene/PLA or PLA exhibit low adhesion to a tantalum substrate, by which the outer layer can be easily transferred (using tweezers, a spatula, or by direct handling) to a 3D-printed graphene/PLA or PLA (polymer) electrode.

An electrode produced with the method according to the invention can be widely applied in electrochemistry or electronics in the form of electronic metal/semiconductor junctions. The advantages of the method include fast electrochemical activation of 3D print, feasible modification of an electrode's active area and size, and operation between 50 to 100 degrees Celsius. The invention is characterised by high electrical conductivity, mechanical stability, low cost and weight, enhanced flexibility, and feasibility of applying substrates sensitive to high temperature.

A graphene/PLA/NDF electrode or graphene/PLA/NDP electrode facilitates the detection of chemical compounds in aqueous solutions and is characterised by a wide range of electrochemical potential windows with low background current levels. The surface of an electrode can be modified to customise the electrode to detect a specific analyte.

Novel design elements of an electrode according to the invention are layers with the use of nanodiamond foils and powders and their superficial bonding to PLA or graphene/PLA in selected layer sizes. Novel elements of the method of producing an electrode are the thermal processes of bonding nanodiamond foils and powders to a PLA substrate.

The invention is described in detailed in the following examples known as embodiment and in drawings where Fig. 1 presents a schematic view of a graphene/PLA/NDF or graphene/PLA/NDP, where W1 is a graphene/PLA layer on the bottom side, provided with a reduced electrical contact EK1, whereas W2 is the outer layer, being a nanodiamond foil or nanodiamond powder located on the top face; Fig. 2 presents a three-electrode measuring system, where E1 is a live graphene/PLA/NDF or graphene/PLA/NDP electrode, E2 is a counterelectrode in the form of a platinum mesh, and E3 is a reference electrode. Fig. 3 presents a voltage-amperometric curve recorded during a measurement made using a potentiostat-galvanostat unit in a three-electrode setup, with a live electrode being a graphene/PLA/NDF or graphene/PLA/NDP electrode.

The examples shown below illustrate the invention.

### Example 1 - a method of producing nanodiamond foil for the production of an electrode - layer W2

The nanodiamond foils (NDF) were produced by microwave plasma-assisted chemical vapour deposition on pre-polished tantalum substrates. All such substrates were pre-cleaned by soaking in acetone and 2-propanol for 10 minutes. Following the pre-cleaning, the substrates were placed for 30 minutes in an ultrasonic bath of an aqueous suspension, which comprised nanodiamond powders with a grain size of 4-7 nm. The substrate temperature, the microwave plasma output power, and the pressure inside the bath chamber were 500°C, 1100 W, and 50 Torr, respectively. The molar ratio of the mixture, CH₄ / H₂, was 1%, while the doping dosage of boron was 500 ppm. The growth time was limited to 300 min, producing a layer thickness of up to 1500 nm.

### Example 2 - a method of producing a graphene-polymer (graphene/PLA) layer

A graphene/polymer electrode in which the weight ratio of graphene to PLA was 5% of graphene by weight and 95% of PLA by weight was produced by FDM 3D-printing under the following conditions: build surface temperature 60°C, extruder temperature 220°C, single layer thickness 0.24 nm, filament flow rate through the extruder 1.5-2 mm³/s.

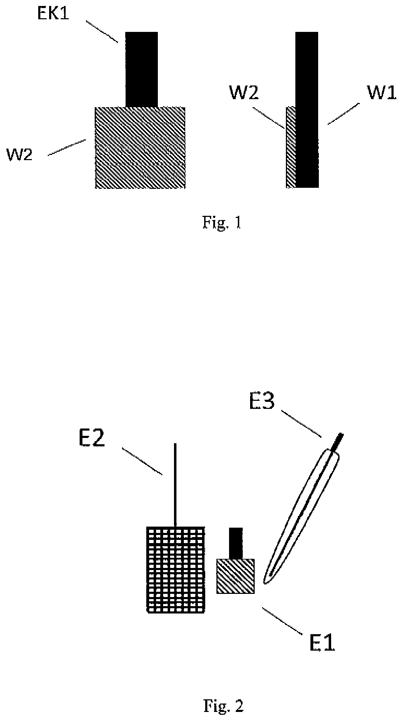

Design of a graphene/PLA electrode. As shown in Fig. 1 to the right, an electrode is built of two layers, where one of them, the inner layer W1 which forms the bottom side of the entire electrode, is graphene/PLA, made of PLA and graphene, wherein the weight ratio of graphene to PLA was 0.5% to 20% of graphene by weight and 99.5% to 80% of PLA by weight; 0.5% of graphene and 99.5% of PLA, or 20% of graphene and 80% of PLA. Layer W1 is made of graphene/PLA and is 0.1 mm to 5 mm thick; in this embodiment, 0.5 mm of thickness was produced, and 5 mm of thickness in the other embodiment. The thickness values are specified so that the outer layer is no more than 0.1% of the entire electrode weight, which is a typical, routine calculation during the production of an electrode.

### Example 3 - a method of producing an entire graphene/PLA/NDF electrode, wherein a nanodiamond layer on a tantalum substrate has its growth surface oriented upward.

The graphene/PLA electrode was produced as shown in Embodiment 2 and placed on a hotplate and a molybdenum sheet. The hotplate was heated at 55°C/min up to 180°C, following which the nanodiamond foil was transferred directly from the substrate using tweezers to the 3D-printed electrode and covered with the molybdenum sheet. At 200°C, the molybdenum sheet was pressed to the surface of the graphene/PLA/NDF electrode and removed from the surface by lifting. Following this, the specimen was cooled down to 35°C within 60 min.

Design of a graphene/PLA/NDF electrode or graphene/PLA/NDP electrode. As shown in Fig. 1, an electrode comprises two layers, the bottom layer of graphene/PLA, W1, is coated on top with an outer layer of nanodiamond foil (NDF). The inner layer is formed of graphene/PLA and its thickness ranges from 0.1 mm to 5 mm in this embodiment. The outer layer is formed of nanodiamond foil (NDF) and its thickness is 50 nm and 1500 nm in this embodiment. The performance of each thickness applied as above was verified.

### Example 4 - a method of producing a graphene/PLA/NDF electrode, wherein a nanodiamond layer has its growth surface oriented downward.

A boron-doped nanodiamond foil on a substrate of tantalum was placed on a hotplate. Following this, a coating was printed on top to form a graphenc/PLA/NDF electrode, as shown in Embodiment 2. At a build surface temperature of 250°C, the tantalum was pressed to the surface of the electrode. Following this, the tantalum was mechanically removed by lifting and the specimen was cooled down to 35°C within 60 min.

Design of a graphene/PLA/NDF electrode or graphene/PLA/NDP electrode. As shown in Fig. 1, an electrode is built of two layers: the bottom layer of graphene/PLA and a nanodiamond foil (NDF). The inner layer is formed of graphene/PLA and its thickness is 0.1 mm and 5 mm in this embodiment. The outer layer is formed of nanodiamond foil (NDF) and its thickness is 50 nm and 1500 nm in this embodiment; both thickness options were produced. The thickness values of both layers are specified so that the outer layer is no more than 0.1% of the entire electrode weight.

**Example** 5 - a method of producing nanodiamond powder (NPD) for the production of the outer layer of an electrode. The nanodiamond powders (NDP) were produced by microwave plasma-assisted chemical vapour deposition on pre-polished tantalum substrates. All such substrates were pre-cleaned by soaking in acetone and 2-propanol for 10 minutes. The substrate temperature, the microwave plasma output power, and the pressure inside the bath chamber were 500°C, 1100 W, and 50 Torr, respectively. The molar ratio of the mixture, CH₄ / H₂, in a mixture of CH₄ / H₂ / B₂H₆ gases was 1%, while the doping dosage of boron was 500 ppm. The growth time was limited to 300 min, producing a diameter of up to 1500 nm.

**Example** 6 - a method of producing an entire graphene/PLA/NDP electrode, wherein a nanodiamond powder layer was deposited on a surface of graphene/PLA.

A boron-doped nanodiamond powder on a substrate of tantalum was placed on a hotplate. Following this, a coating was printed on top to form a graphene/PLA/NDF electrode, as shown in Embodiment 2. At a build surface temperature of 200°C, the tantalum was pressed to the surface of the electrode. Following this, the tantalum was mechanically removed by lifting and the specimen was cooled down to 35°C within 60 min.

Design of a graphene/PLA/NDP electrode. As shown in Fig. 1 to the right, an electrode is built of two layers: the bottom layer of graphene/PLA and a nanodiamond powder (NDP). The inner layer is formed of graphene/PLA and its thickness is 0.1 mm and 5 mm. The outer layer is formed of nanodiamond powder (NDP) and its thickness is 50 nm and 1500 nm in this embodiment. The thickness values are specified so that the outer layer is no more than 0.1% of the entire electrode weight.

### Example 7

Application of graphene/PLA/NDF electrodes and graphene/PLA/NDP electrodes in electrochemical measurements.

As shown in Fig. 1 to the right, an electrode is built of graphene/PLA and a nanodiamond foil (NDF) or nanodiamond powder (NDP). The inner layer is formed of graphene/PLA and its thickness ranges from 0.1 mm to 5 mm. The outer layer is formed of nanodiamond foil (NDF) or nanodiamond powder (NDP) and is 50 nm to 1500 nm thick.

The inner layer is a graphene/PLA electrode with improved flexibility, high electrical conductivity and low weight, whereas the top layer of the electrode is a boron-doped nanodiamond structure that exhibits high electrical conductivity, wide electrochemical potential window, and high SNR (signal-to-noise ratio). Moreover, the nanodiamond foil (NDF) or nanodiamond powder (NDP) is a protective coating against aggressive chemical reagents.

An electrochemical measurement was recorded using a potentiostat-galvanostat in a three-electrode setup, as shown in Fig. 2, which facilitated measurement of the voltage and current characteristics. During the measurement, the current was measured as a function of voltage input. The potential was changed cyclically over time.

Measurements can be done with graphene/PLA/NDF electrodes or graphene/PLA/NDP electrodes from -1 to 1 V (vs. Ag/AgCl/3M KCl) in neutral aqueous solutions.

The setup included a live, graphene/PLA/NDF electrode or graphene /PLA/NDP electrode (E1), a large-surface counter electrode formed by a platinum mesh (E2) and a constant-potential reference electrode of Ag/AgCl/3M KCl (E3). The voltage-amperometric curve was measured from -0.4 V to 0.6 V (vs. Ag/AgCl/3M KCl).

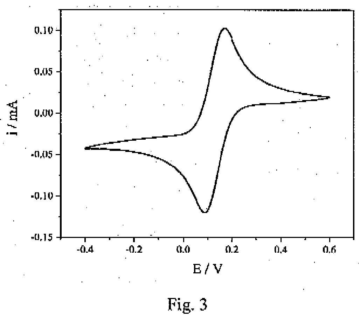

The curve was recorded with a sweep rate of 50 mV s-1 in a 0.5-mol aqueous solution of sodium sulphate (VI) with 5-millimol potassium hexacyanoferrate (III). It is illustrated in Fig. 3. An increase in electrochemical activity was observed with a reduction of charge transmission resistance in both the graphene/PLA/NDF electrodes and graphene/PLA/NDP electrodes in comparison to graphene/PLA electrodes.

## Claims

1. Electrode for electrochemical measurements comprises a polylactic acid fibre, **characterised in that**, it comprises two layers, wherein one inner layer (W1) is made of conductive polylactic acid (PLA) fibre doped with graphene (PLA/graphene), in which the weight ratio of graphene to PLA is from 0.5% to 20% of graphene by weight and from 99.5% to 80% of PLA by weight in the layer of the electrode, and the layer is coated with an outer layer (W2) of nanodiamond foil (NDF) or a layer of nanodiamond powder (NDP), whereas the inner layer of PLA/graphene is 0.1 to 5 mm thick and is coated with a layer 50 nm to 1500 nm thick being up to 0.1% of the entire electrode weight.

2. Electrode according to claim 1, wherein the outer layer is doped with boron or nitrogen.

3. Electrode according to claim 1, wherein the outer layer made of NDF is doped with boron or nitrogen.

4. Method for obtaining of electrode with nanodiamond material in the form of graphene-doped polylactic acid (PLA/graphene) fibre as an inner layer (W1), the method comprises the step of manufacturing of a matrix of PLA/graphene in 3D-printing by Fused Deposition Melting (FDM) and combining it with an outer layer (W2), **characterised in that**, the outer layer is obtained with nanodiamond foil (NDF), preferably doped with boron or nitrogen, or formed of nanodiamond powder (NDP), preferably doped with boron or nitrogen, which is obtained by Microwave Plasma-Assisted Chemical Vapour Deposition (MW PA CVD) in four subsequent steps, where the first step is deposition of NDF or NDP on a substrate preferably pre-polished and made of tantalum or molybdenum or niobium, followed by nucleation and a step of growth, and finally, with removal of superfluous suspension and drying, following which the obtained nanodiamond foil or nanodiamond powders as the outer layer, in a quantity of up to 0.1% of the entire electrode weight is directly deposited by mechanical means on the matrix of 3-D printed PLA/graphene, where the matrix temperature for the nanodiamond foil or nanodiamond powder transfer is 150-300°C.

5. Method according to claim 4, wherein the graphene in the inner layer of the electrode made of conductive polylactic acid fibre doped with graphene is up to 5% by weight.

6. Method according to claim 4, wherein the outer layer of nanodiamond foil or nanodiamond powder is deposited by mechanical means on top of the heated matrix, preferably using tweezers or a spatula.

7. Method according to claim 4, wherein a matrix is printed on the outer layer made of nanodiamond foil or nanodiamond powder, where the matrix is of conductive polylactic acid fibre or graphene-doped conductive polylactic acid fibre, followed by peeling off the nanodiamond foil or nanodiamond powder with the outer layer already bonded to it.

## Patentansprüche

1. Elektrode für elektrochemische Messungen umfasst eine Polylactid-Faser, **dadurch gekennzeichnet, dass** sie zwei Schichten umfasst, wobei eine innere Schicht (W1) aus leitfähiger Polylactid (PLA)-Faser hergestellt ist, die mit Graphen dotiert ist (PLA/Graphen), bei welcher das Gewichtsverhältnis von Graphen zu PLA von 0,5% bis 20% Graphen gewichtsbezogen und von 99,5% bis 80% PLA gewichtsbezogen in der Schicht der Elektrode beträgt, und die Schicht mit einer äußeren Schicht (W2) aus Nanodiamant-Folie (NDF) oder einer Schicht aus Nanodiamant-Pulver (NDP) beschichtet ist, wobei die innere Schicht aus PLA/Graphen 0,1 bis 5 mm dick ist und mit einer Schicht von 50 nm bis 1500 nm Dicke beschichtet ist, die bis zu 0,1% des gesamten Elektrodengewichts ausmacht.

2. Elektrode nach Ansprüche 1, wobei die äußere Schicht mit Bor oder Stickstoff dotiert ist.

3. Elektrode nach Ansprüche 1, wobei die äußere Schicht aus NDF mit Bor oder Stickstoff dotiert ist.

4. Verfahren zur Gewinnung einer Elektrode mit Nanodiamant-Material in Form einer mit Graphen dotierten Polylactid (PLA/Graphen)-Faser als innere Schicht (W1), wobei das Verfahren den Schritt der Herstellung einer Matrix aus PLA/Graphen im 3D-Druck durch Fused Deposition Melting (FDM) und deren Verbindung mit einer äußeren Schicht (W2) umfasst, **dadurch gekennzeichnet, dass** die äußere Schicht mit Nanodiamant-Folie (NDF), vorzugsweise mit Bor oder Stickstoff dotiert, erhalten wird oder aus Nanodiamant-Pulver (NDP), vorzugsweise mit Bor oder Stickstoff dotiert, gebildet wird, welches durch Microwave Plasma-Assisted Chemical Vapour Deposition (MW PA CVD) in vier aufeinanderfolgenden Schritten erhalten wird, wobei der erste Schritt die Abscheidung von NDF oder NDP auf einem Substrat, vorzugsweise vorpoliert und aus Tantal oder Molybdän oder Niob hergestellt, ist, gefolgt von Nukleation und einem Schritt des Wachstums, und schließlich mit Entfernung überflüssiger Suspension und Trocknung, wonach die erhaltene Nanodiamant-Folie oder Nanodiamant-Pulver als äußere Schicht in einer Menge von bis zu 0,1% des gesamten Elektrodengewichts direkt durch mechanische Mittel auf die Matrix aus 3D-gedrucktem PLA/Graphen abgeschieden wird, wobei die Matrixtemperatur für die Nanodiamant-Folie oder Nanodiamant-Pulver-Übertragung 150-300°C beträgt.

5. Verfahren nach Ansprüche 4, wobei das Graphen in der inneren Schicht der Elektrode aus leitfähiger Polylactid-Faser, die mit Graphen dotiert ist, bis zu 5 Gew.-% beträgt.

6. Verfahren nach Ansprüche 4, wobei die äußere Schicht aus Nanodiamant-Folie oder Nanodiamant-Pulver mittels mechanischer Mittel auf der erhitzten Matrix aufgebracht wird, vorzugsweise mit einer Pinzette oder einem Spatel.

7. Verfahren nach Ansprüche 4, wobei eine Matrix auf der äußeren Schicht aus Nanodiamant-Folie oder Nanodiamant-Pulver gedruckt wird, wobei die Matrix aus leitfähiger Polylactid-Faser oder mit Graphen dotierter leitfähiger Polylactid-Faser besteht, gefolgt vom Abziehen der Nanodiamant-Folie oder des Nanodiamant-Pulvers mit der bereits daran gebundenen äußeren Schicht.

## Revendications

1. An electrode pour mesures électrochimiques, en fibre d'acide polylactique (PLA), **caractérisée en ce qu'**elle comprend deux couches,, dans laquelle une couche interne (W1) est formée de fibre conductrice PLA ou de fibre conductrice PLA dopée au graphène, constituant une couche graphène-polymère, dans laquelle le rapport pondéral graphène/PLA est de 0,5% à 20% en poids de graphène et de 99,5% à 80% en poids de PLA au sein d'une même couche de l'électrode ; cette couche est recouverte d'une couche externe (W2) de film de nanodiamant (NDF) ou de poudre de nanodiamant (NDP) ; la couche de PLA ou graphène/PLA a une épaisseur de 0,1 à 5 mm et est recouverte d'une couche de 50 nm à 1500 µm d'épaisseur, représentant jusqu'à 0,1% du poids total de l'électrode.

2. Électrode selon la revendication 1, **caractérisée en ce que** la couche externe est dopée au bore ou à l'azote.

3. Électrode selon la revendication 1, **caractérisée en ce que** la couche externe une feuille de nanodiamant (NDF) est dopée au bore ou à l'azote.

4. Procédé de fabrication d'une électrode en matériau nanodiamant sous forme de fibre d'acide polylactique conductrice dopée au graphène (PLA/graphène) en tant que couche interne (W1), le procédé comprend consistant en la production d'une matrice imprimée en PLA/graphene 3D par fusion-dépôt de fil (FDM) et en combinaison avec une couche externe (W2), **caractérisé en ce que** la couche externe est formée d'une feuille de nanodiamant (NDF), de préférence dopée au bore ou à l'azote, ou d'une poudre de nanodiamant (NDP), de préférence dopée au bore ou à l'azote, laquelle est produite selon une méthode connue de dépôt chimique en phase vapeur assisté par plasma micro-ondes (MW PA CVD) en quatre étapes successives, la première étape étant une deposition NDF ou NDP sur un substrat, de préférence pré-poli et constitué de tantale, de molybdène ou de niobium, suivie d'une nucléation et d'une étape de croissance, et enfin par l'élimination de la suspension superflue et le séchage, après quoi la feuille de nanodiamant ou la poudre de nanodiamant ainsi produite en tant que couche externe, en une proportion allant jusqu'à 0,1% du poids total de l'électrode, est déposée directement par des moyens mécaniques sur une matrice imprimée en 3D de graphène/PLA, la température de la matrice nécessaire pour le transfert de la feuille ou de la poudre de nanodiamant étant comprise entre 150 et 300 °C.

5. Procédé selon la revendication 4, **caractérisé en ce que** la proportion de graphène dans la couche interne de l'électrode constituée de fibre d'acide polylactique (PLA) conductrice dopée au graphène est jusqu'à 5% en poids.

6. Procédé selon la revendication 4, **caractérisé en ce que** la couche externe de feuille de nanodiamant (NDF) ou de poudre de nanodiamant (NDP) est déposée par des moyens mécaniques sur la matrice chauffée, de préférence à l'aide de pinces ou d'une spatule.

7. Procédé selon la revendication 4, **caractérisé en ce qu'**une matrice est imprimée sur la couche externe constituée de feuille de nanodiamant ou de poudre de nanodiamant, la matrice étant réalisée en fibre d'acide polylactique conductrice ou en fibre d'acide polylactique conductrice dopée au graphène, suivie par le décollement de la feuille de nanodiamant ou de la poudre de nanodiamant avec la couche externe déjà liée à celle-ci.
